# EUROPÄISCHE PATENTSCHRIFT

(11) **EP 0 574 797 B1**
(45) Veröffentlichungstag und Bekanntmachung des Hinweises auf die Patenterteilung: **03.09.1997**
(21) Anmeldenummer: 93109163.1
(22) Anmeldetag: 08.06.1993
(51) Int. Cl.: H01L 23/10, H01L 21/50

(54) **Druckglasdurchführung**
Compression glass seal feedthrough
Passage en verre à pression

(30) Priorität: 18.06.1992 DE 4219953
(43) Veröffentlichungstag der Anmeldung: 22.12.1993
(73) Patentinhaber: DIEHL GMBH & CO., 90478 Nürnberg (DE); ELECTROVAC FABRIKATION ELEKTROTECHNISCHER SPEZIALARTIKEL GESELLSCHAFT M.B.H., A-1194 Wien (AT)
(72) Erfinder: Hornig, Wolfgang, Dr., W-8505 Eckenhaid (DE); Findl, Walter, Dipl.-Ing., A-1020 Wien (AT)
(74) Vertreter: Hofmann, Gerhard, Dipl.-Ing. Patentassessor

(56) Entgegenhaltungen:
- EP-A- 0 114 917
- EP-A- 0 163 510
- EP-A- 0 178 481
- WO-A-88/05254
- WO-A-90/02712
- FR-A- 2 120 324
- US-A- 4 128 697
- US-A- 4 349 635
- US-A- 4 678 358
- ELECTRONICS, Bd. 56, Nr. 8, April 1983, New York US, Seiten 155-159; R. LOMERSON : 'Batch-Made Packages Hold Dense ICs, Save Space, Survive Tough Environments'
- EINFÜHRUNG IN DIE DIN-NORMEN, 9. Auflage, Berlin, Beuth Verlag, 1985, Seiten 518,520,522,523,525,526

## Beschreibung

Die Erfindung betrifft die Herstellung von Druckglasdurchführungen mit Fassung aus ausscheidungshärtbaren Legierungen, wobei das Glas als Glasperle in eine Öffnung des auf eine hohe Temperatur erwärmten Metallkörpers (Fassung) eingeschmolzen wird, anschließend ein Innenleiter eingesetzt wird und dann die Druckglasdurchführung auf etwa Raumtemperatur abgekühlt wird, wobei der Ausdehnungskoeffizient des Glases niedriger als der des Metalls ist und eine Verarbeitungstemperatur im Bereich der Solidus-Temperatur des Metalls oder niedriger liegt und wobei die Streckgrenze des Metalls während des Abkühlvorgangs zu keiner Zeit überschritten werden darf.

Derartige Druckglasdurchführungen sind bekannt und in großer Zahl auf dem Markt, vor allem in der Verwendung für Gehäuse von Halbleitern, und dort insbesondere bei Gehäusen für auf einem Substrat aufgebrachte integrierte Schaltungen. Die elektrischen Anschlüsse der Schaltung müssen durch Öffnungen im Gehäuse nach außen geführt werden. Dabei muß eine Isolation gegenüber dem Metallgehäuse erfolgen. Letztere bewirkt eine in die Gehäusedurchführung eingeschmolzene Glasperle, welche in ihrer Mitte den elektrischen Anschlußleiter der Schaltung bei seinem Durchtritt durch das Gehäuse hält. Gleichzeitig hat die Glasperle die Aufgabe, den Innenraum des Gehäuses hermetisch gegenüber der Außenluft abzudichten. Die Gewährleistung dieser hermetischen Dichtung, welche über einen großen Temperaturbereich funktionsfähig sein soll, ist bei der Herstellung einer solchen Druckglasdurchführung gefordert.

Bei derartigen Druckglasdurchführungen muß der thermische Ausdehnungskoeffizient des Metallkörpers wesentlich höher sein als der des Einschmelzglases und des metallischen Innenleiters. Nach dem Einschmelzen des Glases in den auf hohe Temperatur erwärmten Metallkörper schrumpft während der nachfolgenden Abkühlung das äußere Metallteil infolge seiner wesentlich höheren Kontraktion auf den Glaskörper auf. Da die Druckfestigkeit von Gläsern deren Zugfestigkeit um das 10 bis 20-fache übersteigt, kann dies bei der Druckglaseinschmelzung dahingehend ausgenutzt werden, daß durch die Vorgabe einer allseitigen, hohen Druckspannung auf den Glaskörper das Auftreten von Zugspannungen im Glas auch bei starker mechanischer und/oder thermischer Beanspruchung der Glasdurchführung sicher vermieden wird.

Die durch das Aufschrumpfen des Metallteiles während der Abkühlung auf den Glaskörper aufgebrachten Druckspannungen bewirken im Metallteil tangential gerichtete Zugspannungen von erheblicher Größe. Durch geeignete Dimensionierung von Metallkörper und Bohrungen sowie durch geeignete Werkstoffauswahl (Metall, Glas) muß vermieden werden, daß im Metallkörper plastische, d.h. bleibende Verformungen durch Überschreiten der Elastizitätsgrenze (Streckgrenze) auftreten. Dies hätte nämlich zur Folge, daß bei thermischer Beanspruchung die erforderliche Druckspannungsreserve nicht mehr vorhanden wäre, was wiederum zu einer verminderten thermischen und mechanischen Schockfestigkeit der Druckglasdurchführung sowie dazu führen würde, daß deren Vakuumdichtheit bereits bei Raumtemperatur und ohne jede Belastung nicht mehr besteht. Deshalb ist es erforderlich, daß Zugfestigkeit und Streckgrenze des verwendeten Metalls genügend hoch liegen.

Bisher werden für solche Druckglasdurchführungen im wesentlichen Eisen-Nickel-Legierungen und Stahl verwendet. Es sind für Sonderanwendungen, nämlich für Gehäuse von Herzschrittmachern, auch schon Titanlegierungen verwendet worden, welche jedoch aufgrund der besonderen physiologischen Anforderungen Eigenschaften aufweisen müssen, die sich deutlich unterscheiden von jenen, die bei üblichen Metallkörpern gefordert werden.

Die genannten Legierungen aus Eisen-Nickel und Stahl besitzen eine Streckgrenze von >200 N/mm² sowie einen Wärmeausdehnungskoeffizienten α von etwa 80 ö 180 x 10⁻⁷/°C. Letzterer unterscheidet sich deutlich von dem Wärmeausdehungskoeffizienten der geeigneten Gläser der bei etwa 45 ö 100 x 10⁻⁷/°C liegt. Diese genannten Materialien haben den Vorteil, daß sie ihre hohe Streckgrenze auch während des Abkühlens nach dem Einschmelzvorgang wieder erlangen, und aufgrund des unterschiedlichen Wärmeausdehnungskoeffizienten zu Glas, auch während des Abkühlvorgangs und bei Raumtemperatur noch einen hohen Überschuß an Druckspannung auf den Glaskörper ausüben können.

Aus den Druckschriften US-A-4 678 358 und US-A-4 349 635 sind derartige Metallgehäuse mit einer Druckeinglasung bekannt geworden. Die erstgenannte Druckschrift beschreibt auch die Verwendung von Aluminium für das Gehäuse.

Materialien der vorgenannten Art erfüllen jedoch nicht mehr die steigenden Anforderungen, die an zukünftige Gehäuse für Halbleiter gestellt werden und die insbesondere durch eine höhere Wärmeleitfähigkeit, leichte Bearbeitbarkeit, hohe peraturwechselbeständigkeit und niedrigeren Preis gekennzeichnet sind.

Die auf dem Markt befindlichen üblichen Kupfer- und Aluminiumlegierungen, welche teilweise über derartige Eigenschaften verfügen, haben jedoch eine so niedrige Streckgrenze, daß bei ihnen bereits während des Abkühlvorganges eine plastische Verformung eintritt und damit die Druckglasdurchführung nicht hermetisch dicht herstellbar ist.

Neben der vorstehend beschriebenen Art von Metall-Glasverschmelzung, nämlich der Druckglasdurchführung, gibt es noch die sogenannte abgestimmte Durchführung, welche nicht Gegenstand der Erfindung ist, aber zum Vergleich für die Vorteile der Erfindung herangezogen wird. Diese Durchführung ist dadurch gekennzeichnet, daß sämtliche Verschmelzungspartner (Metallaußenteil, Glaskörper, metallischer Innenleiter) "abgestimmt" sind, d.h. daß ihre thermischen Ausdehnungskoeffizienten über einen weiten Temperaturbereich annähernd gleich sind. Dies hat zur Folge, daß in einem solchen Anwendungsfall nicht mit dem Auftreten von Spannungen infolge terschiedlicher Kontraktion während des Abkühlens zu rechnen ist und somit die Streckgrenze des äußeren Metallteils kein entscheidendes Kriterium für die Auslegung eines solchen Gehäuses darstellt.

Für derartige "abgestimmte" Durchführungen werden heute (in der sogenannten "tiefgelegten abgestimmten" Ausführung) Eisen-Nickel-Kobalt-Legierungen verwendet, die unter dem Namen Kovar im Handel sind. Diese haben in etwa einen Wärmeausdehnungskoeffizienten von 45 - 55 x 10⁻⁷/°C. Der Ausdehnungskoeffizient der dazu verwendeten Gläser und der metallischen Innenleiter liegt in der gleichen Größenordnung.

Der Einsatz von Kovar hat den Vorteil, daß die thermische Belastbarkeit (Temperatur- und Schockbeständigkeit) eines aus einem solchen Material gefertigten Gehäuses beträchtlich höher ist als bei den üblichen Druckglasdurchführungen. Vor allem dort, wo hohe Zuverlässigkeit des Bauteils in Verbindung mit kritischem Temperatureinfluß gefordert ist, greift man daher bevorzugt auf diese inzwischen längst bewährte Konzeption zurück.

Denkbar und, wenn auch nur in geringem Maße, realisiert ist die Variante der "hochgelegten abgestimmten" Durchführung, bei der die Verschmelzpartner wiederum etwa gleiche thermische Ausdehnung aufweisen, der Absolutwert nun jedoch im Bereich von 80 - 100 x 10⁻⁷/°C liegt. Durchführungen mit noch höherem Ausdehnungskoeffizienten sind ebenfalls denkbar, kommen jedoch, zum einen weil die dazu benötigten Gläser nur geringe chemische Resistenz und ungenügende Isolationseigenschaften aufweisen und somit für zuverlässige Anwendungen nicht geeignet sind, zum anderen wegen der Tatsache, daß mit steigendem Ausdehnungskoeffizienten der abgestimmten Materialpaarungen die Temperaturwechselbeständigkeit stark abnimmt, praktisch nicht zum Einsatz.

Der Vorteil der guten Temperatur-Wechselbeständigkeit kommt somit nur bei "tiefgelegten abgestimmten" Durchführungen zum Tragen. Kovar-Gehäuse werden heute eingesetzt, obwohl sie gegenüber Druckglasdurchführungen wesentlich teurer sind, den nicht unerheblichen Nachteil der schlechten Wärmeleitfähigkeit aufweisen, und das Material schlechter bearbeitbar ist.

Es wäre somit wünschenswert eine Druckglasdurchführung aus einem leichter als Kovar bearbeitbaren Material herzustellen, die sich einerseits durch verbesserte physikalische Eigenschaften auszeichnet, trotzdem die kritischen Anforderungen erfüllt und Kovar hinsichtlich Temperaturwechselbeständigkeit ebenbürtig ist.

Es sind auch sogennante Ein-Chip-Gehäuse bekannt geworden, siehe WO 88/05254 und WO 90/02712, bei welchen metallische Leiter in einen Glasring eingeschmolzen werden und dieser Ring an seiner Ober- und an seiner Unterseite je mit einem Deckel, der an den Ring geklebt wird, zu einem Gehäuse aufgebaut werden, in dem ein Halbleiter-Chip an die metallischen Leiter gebondet ist. Bei derartigen Gehäusen sind die Ausdehnungskoeffizienten von Glas, Deckeln und metallischen Leitern aufeinander ,,abgestimmt'', d. h. sie liegen möglichst nahe beieinander. Eine Druckeinglasung liegt hier nicht vor.

Aufgabe der Erfindung war es daher, Legierungen vorzuschlagen, welche eine gute Wärmeleitfähigkeit, gute Verarbeitbarkeit und Herstellbarkeit, vor allem aber eine hohe Temperaturwechselbeständigkeit und Korrosionsbeständigkeit besitzen. Die Lösung der der Erfindung gestellten Aufgabe besteht nun darin, daß eine Metallegierung aus dem Legierungssystem Kupfer mit spinodaler Aushärtung verwendet ist und daß diese Legierung von einer Temperatur von 800 °C bis 1000 °C so schnell abgekühlt wird, daß eine spinodale Aushärtung erfolgt, wobei die Abkühlgeschwindigkeit mindestens 10 °C/min beträgt.

Die Erkenntnis der Erfindung besteht somit darin, daß solche Legierungen zur Anwendung kommen sollen, welche - im Gegensatz zu üblichen Legierungen - einen Aushärteeffekt durchmachen, wie er insbesondere bei spinodalen Legierungen gegeben ist. Dadurch wird erreicht, daß diese Legierungen bei der Abkühlung ihre Streckgrenze derart erhöhen, daß bei Abkühlung auf Raumtemperatur oder sogar auf negative Temperaturen diese Streckgrenze des Metalls nicht überschritten wird.

Für die Auswahl solcher Legierungen gilt die einschränkende Bedingung, daß der optimale Abkühlvorgang, der zu dieser Streckgrenzenerhöhung führt, so verläuft, daß dieser auch auf das Erstarrungsverhalten des Glases während der Abkühlung abgestimmt ist. Nur auf diese Weise ist sichergestellt, daß bei der gemeinsamen Abkühlung von Metallkörper und Glas die Streckgrenze des Metalls nicht überschritten und somit Beschädigungen im Grenzbereich zwischen Metall und Glas vermieden werden.

Aushärtbare Nichteisenmetall-Legierungen, die die der Erfindung gestellt Aufgabe lösen und die vorstehend erläuterten Bedingungen erfüllen, sind aus dem System Kupfer auswählbar.

Als besonders vorteilhaft im Sinne der Erfindung haben sich Legierungen der Zusammensetzung Kupfer (Rest), 0,1 ö 10 % Ni, 0,1 ö 12 % Sn und 0 ö 0,4 % Mn erwiesen. Dabei wurde gefunden, daß Legierungen mit einem hohen Nickel- und Zinngehalt bis zu einem hohen Temperaturbereich (Arbeitstemperatur) hermetisch dicht bleiben, wohingegen Legierungen mit niedrigem Nickel- und Zinngehalt eine deutlich höhere Wärmeleitfähigkeit aufweisen, aber nur bis zu einer niedrigeren Arbeitstemperatur hermetisch dicht bleiben. Eine sehr gute wechselbeständigkeit vor allem der erstgenannten Gruppe von Legierungen und eine sehr gute Korrosionsbeständigkeit, die eine nachträgliche Oberflächenvergütung unnötig macht, sind hervorstechende Eigenschaften dieser Legierungen.

Es wurde ferner gefunden, daß sich im Sinne der Erfindung auch Legierungen der Zusammensetzung Cu (Rest) 0,1 ö 5 % Cr und 0,01 ö 5 % Zr gut eignen.

Aus dem Bereich der Aluminiumlegierungen sind vorzugsweise solche der Zusammensetzung Al Cu Zn Mg oder Al Zn Mg auszuwählen.

Als Gläser für den Einschmelzvorgang werden handelsübliche Gläser verwendet, wie sie beispielsweise von den Firmen Nippon Electric oder Corning Glas unter der Bezeichnung Corning 7052, Corning 9013 oder Nippon ST4 auf den Markt gebracht werden. Gläser der letztgenannten Art haben eine Zusammensetzung 65 % SiO₂, 5 % Al₂O₃, 15 % BaO und ZnO und 15 % Na₂O + K₂O + LiO₂ (alle Angaben in Gewichtsprozent).

Ein großes Anwendungsgebiet von Druckglasdurchführungen ist bei Gehäusen von Halbleitern gegeben, insbesondere bei solchen, welche für sogenannte Hybridschaltungen verwendet werden. Dies sind auf einem Keramiksubstrat oder dergleichen aufgebrachte integrierte Schaltkreise, wobei auf dem Substrat zusätzlich noch weitere Bauteile aufgebracht sein können. Solche Gehäuse werden zunehmend Verwendung finden in der Leistungs- und Mikroelektronik, in der Optoelektronik und der Sensorik. In diesem Zusammenhang ist es günstig, daß z.B. die vorstehend genannten Kupferlegierungen eine gute Laser-Schweißbarkeit besitzen. Dies ist wichtig, weil der Deckel, der das Gehäuse verschließen soll, ebenfalls eine hermetische Dichtung bilden muß. Dabei darf das Gehäuse und dessen Inhalt durch den Schweißvorgang nicht beschädigt werden.

Die Druckglasdurchführung wird von einer Temperatur von 800 - 1000°C mit einer Geschwindigkeit > 10°C/min auf etwa Raumtemperatur abgekühlt. Eine derartige Abkühlung kann z.B. durch eine geeignete Ausbildung der Ofenkühlstrecke erfolgen.

Eine Erhöhung der Streckgrenze während des Abkühlvorgangs erhält man in Weiterbildung der Erfindung dadurch, daß während des Abkühlvorganges die Temperatur, vorzugsweise im Bereich von 250 - 450°C, für mehrere Minuten bis zu mehreren Stunden konstant gehalten wird, ehe weiter abgekühlt wird.

Zusätzlich zu der vorgenannten Maßnahme und mit dem Ergebnis einer weiteren Streckgrenzenerhöhung kann im Sinne der Erfindung weiter vorgesehen werden, daß die Druckglasdurchführung nach dem Abkühlvorgang auf eine Temperatur zwischen 250°C und 450°C, vorzugsweise etwa 320°C wieder aufgeheizt und für 1 Minute bis 10 Stunden, vorzugsweise 2 - 6 Stunden warm ausgelagert wird.

Ein ähnliches Ergebnis ist dadurch zu erzielen, daß die Druckglasdurchführung nach dem Abkühlvorgang auf eine Temperatur von wenigstens 250°C aufgeheizt und von dort stufenweise bis höchstens 450°C erwärmt und dabei in jeder Stufe zwischen 1 Minute und 2 Stunden gehalten wird.

Diese und noch andere Weiterbildungen der Erfindung sind in den Unteransprüchen gekennzeichnet.

Nachfolgend soll die Erfindung anhand der Zeichnungen noch näher erläutert werden.

Es zeigen:
- Fig. 1: ein Hybrid-Gehäuse für eine integrierte Schaltung in einer Ansicht von oben;
- Fig. 2: das Gehäuse in einer Ansicht in Richtung Pfeil A der Fig. 1;
- Fig. 3: eine Druckglasdurchführung gemäß Fig. 2 in vergrößerter Darstellung;
- Fig. 4: eine Skizze der prinzipiellen Abhängigkeit des Wärmeausdehnungskoeffizienten von der Temperatur bei Glas und Metall;
- Fig. 5: eine Skizze des prinzipiellen Verlaufs der Grenzkurven für die Abkühlgeschwindigkeit des Systems Glas-Metall;
- Fig. 6: eine Gegenüberstellung einiger physikalischer Werte der Legierungen nach der Erfindung zu Vergleichsmaterialien.

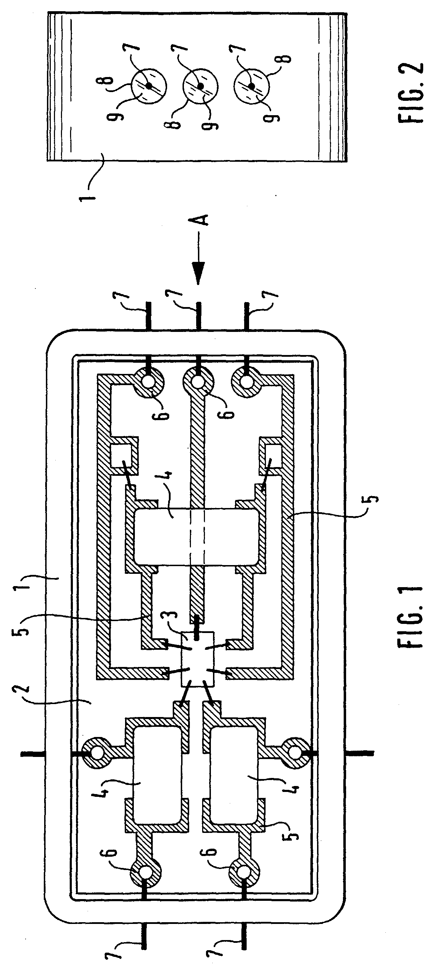

In Fig. 1 ist ein Hybridgehäuse 1, gefertigt aus einer aushärtbaren Legierung, in einer Ansicht von oben gezeigt. Auf dem Gehäuseboden befindet sich eine Keramiksubstrat-Platte 2, auf welcher ein integrierter Schaltkreis 3 sowie elektronische Baugruppen 4 angeordnet und durch Leiterbahnen 5 miteinander verbunden sind. Die Endpunkte 6 der Leiterbahnen sind über elektrische Leiter 7 durch hier nicht dargestellte Glasdurchführungen aus dem Gehäuse herausgeführt. Auf das Gehäuse wird nach Einbringen der Keramiksubstratplatte 2 und Aufbaus der Hybridschaltung ein Deckel, vorzugsweise gleichen Materials aufgeschweißt. Dies geschieht vorzugsweise mittels eines Lasers. Die Besonderheit ist, daß dieses Gehäuse hermetisch gegen die Außenwelt abgeschlossen sein muß, um schädliche Einflüsse, wie Gase oder Feuchtigkeit, von seinem Innenraum fernzuhalten.

In Fig. 2 ist das Metallgehäuse 1 in einer Ansicht A dargestellt. Man erkennt in dem Metallgehäuse drei Bohrungen 8, in denen sich die Leiter 7 befinden. Diese Bohrungen 8 sind durch eingeschmolzene Glasperlen 9 ausgefüllt und hermetisch sowohl gegen das Metallgehäuse 1 als auch gegen den Leiter 7 abgedichtet.

Die Abdichtung der Leiter 7 durch die Glasperlen 9 stellt kein größeres technisches Problem dar und ist nicht Gegenstand der Erfindung. Wichtig ist in diesem Zusammenhang nur, daß der Ausdehnungskoeffizient des Leiters 7 und der Glasperle 9 in etwa gleich ist. Das von der Erfindung zu lösende Problem besteht in der Abdichtung der Grenzfläche Metallgehäuse 1 gegen Glasperle 9.

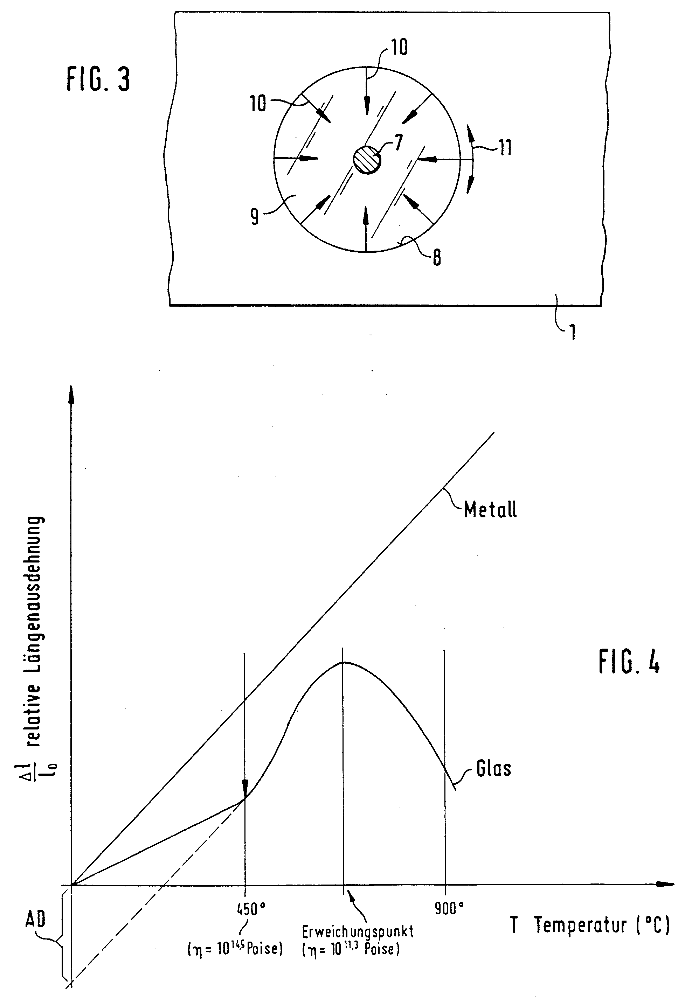

Anhand der Figuren 3 und 4 soll der Wirkungsmechanismus der Druckglasdurchführung näher erläutert werden. Um an der Grenzfläche Metallgehäuse zu Glasperle 9 eine gute Abdichtung zu erhalten, müssen hohe Druckkräfte vom Metall auf das Glas ausgeübt werden. Dabei ist es wichtig zu wissen, daß Glas hohe Druckkräfte aber nur geringe Zugkräfte aufnehmen kann, ohne zerstört zu werden. Wichtig ist ferner, daß nach dem Einschmelzen der Glasperle 9 in die Bohrung 8, was bei etwa 950°C geschieht, während des Abkühlens ein Druckspannungsaufbau erfolgt. Wie aus der Fig. 3 ersichtlich ist, treten neben den Druckkräften, Pfeile 10, auch tangentiale Zugkräfte, Pfeile 11, im Metallgehäuse 1 auf. Diese tangentialen Zugkräfte sind umso größer, je größer auch die Druckkräfte sind. Entscheidend für eine hermetisch dichte Einglasung ist es, daß die Streckgrenze des Metalls während des Abkühlvorganges oder danach nicht durch diese Tangentialkräfte überschritten wird. Wäre dies der Fall, so wäre die Bohrung nicht mehr dicht zu bekommen.

Wichtig ist, daß das Metall infolge des hohen Wärmeausdehnungskoeffizienten gegenüber dem Glas und seiner hohen Streckgrenze, auch nach dem Abkühlvorgang noch einen Überschuß an Druckkräften auf die eingeschmolzene Glasperle 9 ausüben kann. Erreicht wird dies durch Verwendung von Glassorten mit geringem Ausdehnungskoeffizienten, der deutlich niedriger sein soll als der des Metalls. Typische Werte bei den hier beschriebenen Metallpaarungen sind Ausdehnungskoeffizienten α von 80 - 180 x 10⁻⁷/°C für das Metall und 45 - 110 x 10⁻⁷/°C für das Glas.

Die Höhe der auftretenden Druckspannungen ist abhängig von der Differenz der Ausdehnungskoeffizienten Δα von Metall und Glas.

Die zu verwendenden Gläser sollen darüber hinaus gute chemische Resistenz gegen korrosive Atmosphäre und gute onseigenschaften aufweisen.

In Fig. 4 sind die thermischen Ausdehnungskoeffizienten von Metall und von für den vorliegenden Anwendungsfall charakteristischen Gläsern in Abhängigkeit von der Temperatur in qualitativer Darstellung aufgezeigt. Zur Verdeutlichung der Druckspannungen, welche das Metall auf das Glas während des Abkühlens ausübt, dient die Größe des Abstandes zwischen beiden Kurven. Je größer dieser Abstand beispielsweise bei der Temperatur von 450°C ist, desto größer sind die Druckspannungen bei Raumtemperatur, vorausgesetzt, daß das Metall eine genügend hohe Festigkeit besitzt, um den auftretenden tangentialen Zugkräften ohne plastische Verformung bis zur Raumtemperatur standhalten zu können. Bei etwa 450°C ist der sogenannte Strain Point des Glases, bei welchem das Glas eine Viskosität von η = 10^{14,5} [Poise] hat. Ab dieser Temperatur beginnt das in das Metallteil eingeschmolzene Glas bei Abkühlung aufgrund der weiter abnehmenden Viskosität Spannungen aufzunehmen.

Mit AD ist in Fig. 4 ein Maß für die Größe der Druckspannungen bei Raumtemperatur gegeben. Es ist ersichtlich, daß AD mit größer werdender Differenz der Ausdehnungskoeffizienten von Metallaußenteil und Glas größer wird, und somit größere Druckspannungen hervorgerufen werden, die ihrerseits aber, um eine Plastifizierung zu vermeiden, wiederum eine höhere Streckgrenze des Metalls erforderlich machen.

Es wurde nun gefunden, daß Legierungen des Systems Cu Ni Sn Mn, anders als übliche Kupferlegierungen, ihre Streckgrenze beim Abkühlen von hoher Temperatur wesentlich erhöhen, so daß trotz des Ausdehnungsunterschiedes von Metall und Glas kein Überschreiten der Streckgrenze zu erwarten ist. Es wurde weiter festgestellt, daß Legierungen mit niedrigem Nickel- und Zinngehalt zwar eine gute Wärmeleitfähigkeit, aber keine sehr hohe Streckgrenze aufweisen. Dies Legierungen sind aufgrund des vorstehend beschriebenen Verhaltens beim Abkühlen für die hermetische Abdichtung geeignet, sie üben jedoch keine so hohen Druckspannungen bei Raumtemperatur auf den Glaskörper aus wie die höherlegierten Legierungen. Dies hat zur Folge, daß bei einem sehr niedrigen Temperatur-Arbeitsbereich des fertigen Gehäuses, z.B. unter 0°C, die Dichtheit ganz verschwinden würde. Deshalb werden die niedriglegierten Legierungen hauptsächlich dort eingesetzt, wo eine sehr hohe Wärmeleitfähigkeit gefordert ist, der Arbeitsbereich eher im niederen Temperaturbereich liegt. Anders ist es hingegen bei den Legierungen mit hohem Nickel- und Zinngehalt. Es treten bei äußerst hohen Streckgrenzen und noch immer guter Wärmeleitfähigkeit die besonderen Vorteile der Legierung zutage. Aufgrund der hohen Streckgrenze können diese Legierungen in einem sehr hohen Temperaturbereich von z.B. -60 bis 500°C als Prüftemperatur betrieben werden. Dies bedeutet, daß die "Reserve" der hermetischen Dichtung sehr groß ist, also eine sehr gute Temperaturwechselbeständigkeit gegeben ist.

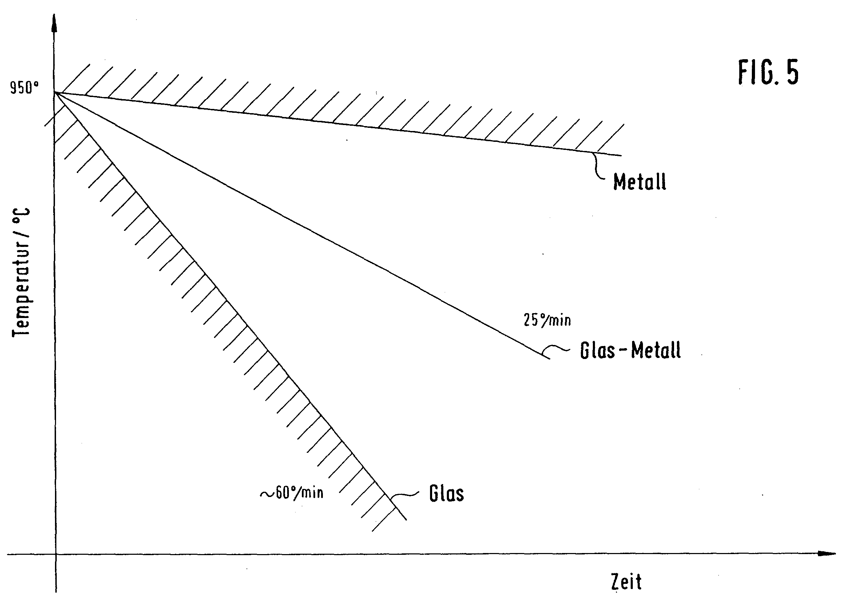

In Fig. 5 sind in einer Prinzipskizze die Grenzkurven für die möglichen Abkühlkurven einer Druckglasdurchführung dargestellt. Man erkennt, daß die Grenzkurve für Glas ziemlich steil verläuft, d.h. das Glas kann relativ schnell abgekühlt werden. Die Grenzkurve für die langsame Abkühlung von Metall verläuft ziemlich flach, es kann sehr langsam abgekühlt werden. Das System Metall-Glas kann bei der Abkühlung, die in einem Ofen nach einem festgelegten Abkühlungsprofil vorgenommen wird, durchaus in einem breiten Temperaturbereich abgekühlt werden. Erfolgt die Abkühlung jedoch zu schnell, so wird die Ausdehnungscharakteristik von Glas geändert; daher ist eine Begrenzung nach oben in der Abkühlgeschwindigkeit erforderlich. Erfolgt die Abkühlung zu langsam, so wird im Metall zu wenig Potential für den Aushärteprozeß erreicht. Der Bereich der Abkühlgeschwindigkeit sollte daher minimal etwa 10°C/min und maximal etwa 60°C/min betragen.

Aus Tabelle 1 ist entnehmbar, daß sich bei Legierungen des Typs CuNiSn die Streckgrenze während des Abkühlens entsprechend erhöht. Die dargestellten Legierungen befinden sich nach der Abkühlung in einem Zustand ohne jede Nachbehandlung. Die Tabelle zeigt die Ergebnisse von Versuchen, bei denen die Streckgrenze Rp_{o,2} und die Zugfestigkeit Rm eines weichgeglühten Materials (Metall) vor einem Wärmeprozeß, wie er bei einer Einglasung verwendet wird, (750°C, 30 min, dann wasserabgeschreckt) und nach einem solchen Prozeß gemessen wurden.

Man erkennt, daß die Streckgrenze nach dem Wärmeprozeß und mit zunehmendem Zinn- und Nickelgehalt der Legierung sogar deutlich ansteigt. Ein ähnliches Verhalten zeigt die Zugfestigkeit ab Nickelgehalten von mehr als 2%.

**Tabelle 1**

| **Legierung** | **DIEHL-Nr.** B = Band ZP = Zugpr. | **Zug (vor)** Rp0,2/Rm [N/mm²] | **Zug (nach)** Rp0,2/Rm [N/mm²] |
|---|---|---|---|
| Sn1 Ni1 | 1 B/ZP | 81 / 247 | 81 / 245 |
| Sn2 Ni1,5 | 2 B/ZP | 80 / 273 | 80 / 260 |
| Sn3 Ni2,5 | 3 B/ZP | 99 / 298 | 101 / 283 |
| Sn4 Ni2 | 4 B/ZP | 111 / 306 | 116 / 311 |
| Sn4 Ni3 | 5 B/ZP | 115 / 317 | 121 / 323 |
| Sn4 Ni5 | 7 B/ZP | 120 / 333 | 130 / 344 |
| Sn8 Ni3 | 9 B/ZP | 152 / 354 | 160 / 365 |
| Sn8 Ni5 | 10 B/ZP | 169 / 385 | 190 / 397 |
| Sn8 Ni7 | 11 B/ZP | 173 / 399 | 253 / 407 |
| Sn8 Ni8 | 12 B/ZP | 181 / 409 | 298 / 487 |

Es wurde nun gefunden, daß durch eine Wärmebehandlung anschließend an das Abkühlen die Streckgrenze der Legierung weiter erhöht werden kann. Die entsprechenden Verhältnisse sind in Tabelle 2 dargestellt.

Man erkennt am Beispiel der Legierung Cu Sn2 Ni9, daß bei einer Erwärmung auf 320°C und Halten dieser Temperatur während einer Zeit von zwei Stunden die Streckgrenze von etwa 93 auf 125 N/mm² ansteigt. Wird anschließend während weiterer 5 Stunden auf 320°C erwärmt, so steigt die Streckgrenze auf etwa den Wert 170.

**Tabelle 2**

| | Streckgrenze Rp_{o,2} [N/mm²] | Zugfestigkeit Rm [N/mm²] |
|---|---|---|
| Wert nach dem Einglasungsprozeß | 93 | 312 |
| zusätzlich 2h, 320°C | 125 | 344 |
| zusätzlich 7h, 320°C | 170 | 386 |

Eine deutliche Erhöhung ergibt sich auch bei der Zugfestigkeit.

Eine deutliche Erhöhung der Streckgrenze während des Abkühlvorganges ergibt sich auch bei den untersuchten Legierungen CuCrZr. Dort steht im Vordergrund die sehr hohe Wärmeleitfähigkeit, wohingegen die Streckgrenzenerhöhung, ebenfalls merkenswert, aber in ihrem Absolutwert gegenüber den hochlegierten CuNiSn-Legierungen zurückbleibt. Legierungen dieses Typs wird man daher vorzugsweise dort einsetzen, wo es auf besonders hohe Wärmeleitfähigkeit, aber wegen der geringeren Druckspannung nicht auf hohe Arbeitstemperaturen ankommt.

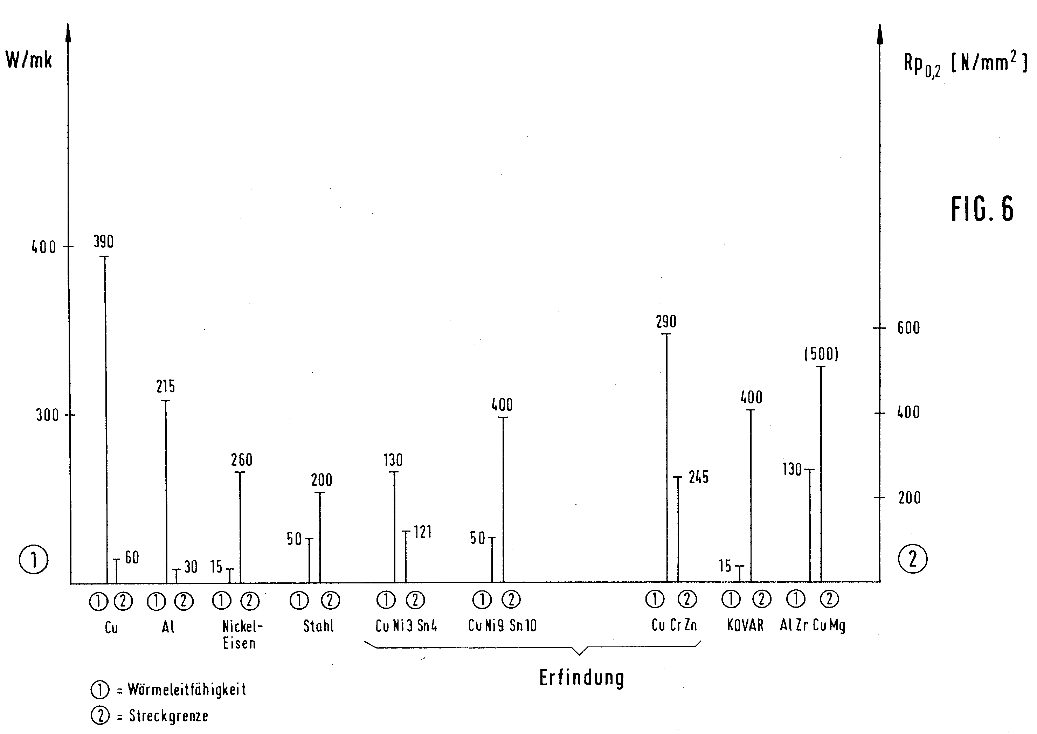

In Fig. 6 sind die Legierungen gemäß der Erfindung und einige Vergleichsmaterialien einander gegenübergestellt. Man erkennt hier den Unterschied der gemäß der Erfindung vorgesehenen Legierungen gegenüber den Vergleichsmaterialien.

Wenngleich die aufgeführten Meßwerte der Legierungen CuNiSn an in Bandform vorliegendem Material gemessen worden sind, so kann bei in etwa gleichen Eigenschaften die Legierung auch in Form von Gußteilen, Schmiedeteilen oder stranggepreßten Stangen vorliegen.

Für die Herstellung von Druckglasdurchführungen mit Legierungen des Typs CuNiSn ist es wichtig, daß die Aufschmelztemperatur der Legierung höher als die Einglasungstemperatur des Glases liegt, d.h. über 950°C. Die Abkühlung erfolgt nach dem Einschmelzen der Glasperle in die Bohrung des Gehäuses und dem Einsetzen des Leiters in den Glasschmelzfluß und wird zweckmäßigerweise mit einer Geschwindigkeit von etwa 10° bis 25°C/min durchgeführt. Dabei kann der Gradient der Abkühlung im höheren Temperaturbereich Werte bis etwa 50°C/min und auch etwas höher erreichen, er sollte jedoch den Wert von 10°C/min möglichst nicht unterschreiten. Die abgekühlte Druckglasdurchführung wird anschließend nochmals auf etwa 320°C erwärmt und für etwa 2 Stunden auf konstanter Temperatur warm ausgelagert. Je nach dem gewünschten Verwendungszweck wird man hoch- oder niedriglegierte Legierungen für diesen Zweck verwenden. Es hat sich als zweckmäßig erwiesen, Mangan bis zu maximal 0,4 % der Legierung zuzusetzen, um Aufschmelztemperaturen über 950°C zu erreichen.

## Patentansprüche

1. Herstellung von Druckglasdurchführungen mit Fassung aus ausscheidungshärtbaren Legierungen, wobei das Glas als Glasperle in eine Öffnung des auf eine hohe Temperatur erwärmten Metallkörpers eingeschmolzen wird, anschließend ein Innenleiter eingesetzt wird und dann die Druckglasdurchführung auf etwa Raumtemperatur abgekühlt wird, wobei der Ausdehnungskoeffizient des Glases niedriger als der des Metalls ist und eine Verarbeitungstemperatur im Bereich der Solidus-Temperatur des Metalls oder niedriger liegt und wobei die Streckgrenze des Metalls während des Abkühlvorgangs zu keiner Zeit überschritten werden darf,
dadurch gekennzeichnet,
daß eine Metallegierung aus dem Legierungssystem Kupfer mit spinodaler Aushärtung verwendet ist und daß diese Legierung von einer Temperatur von 800 °C - 1000 °C so schnell abgekühlt wird, daß eine spinodale Aushärtung erfolgt, wobei die Abkühlgeschwindigkeit mindestens 10 °C/min beträgt.

2. Herstellung einer Druckglasdurchführung nach Anspruch 1,
dadurch gekennzeichnet,
daß Legierungen der Zusammensetzung Cu (Rest), 0,1 - 10 % Ni 0,1 - 12 % Sn 0 - 0,4 % Mn verwendet sind.

3. Herstellung einer Druckglasdurchführung nach Anspruch 1,
dadurch gekennzeichnet,
daß Legierungen der Zusammensetzung Cu (Rest), 0,1 - 5 % Cr, 0,01 - 5 % Zr verwendet sind.

4. Herstellung einer Druckglasdurchführung nach Anspruch 1,
dadurch gekennzeichnet,
daß eine Legierung des Systems Al Cu Zn Mg verwendet ist.

5. Herstellung einer Druckglasdurchführung nach Anspruch 1,
dadurch gekennzeichnet,
daß Gläser der Zusammensetzung 65 Gewichts-% SiO₂, 5 % Al₂O₃, 15 % BaO+ZnO und 15 % Na₂O + K₂O + Li₂O verwendet sind.

6. Herstellung einer Druckglasdurchführung nach Anspruch 1,
dadurch gekennzeichnet,
daß während des Abkühlvorganges die Temperatur, vorzugsweise im Bereich von 250 - 450 °C, für mehrere Minuten bis zu mehreren Stunden konstant gehalten wird.

7. Herstellung einer Druckglasdurchführung nach Anspruch 1,
dadurch gekennzeichnet,
daß die Druckglasdurchführung nach dem Abkühlvorgang auf eine Temperatur zwischen 250 °C und 450 °C, vorzugsweise etwa 320 °C, aufgeheizt und für 1 Minute bis 10 Stunden, vorzugsweise 2 bis 6 Stunden, warm ausgelagert wird.

8. Herstellung einer Druckglasdurchführung nach Anspruch 1,
dadurch gekennzeichnet,
daß die Druckglasdurchführung nach dem Abkühlvorgang auf eine Temperatur von wenigstens 250 °C aufgeheizt und von dort stufenweise bis höchstens 450 °C erwärmt und dabei in jeder Stufe zwischen 1 Minute und 2 Stunden gehalten wird.

9. Herstellung einer Druckglasdurchführung nach Anspruch 1,
dadurch gekennzeichnet,
daß die Druckglasdurchführung einen oder mehrere im Glas eingebettete und durch dieses gegen den Metallkörper isolierte Innenleiter aufweist, wobei die Wärmeausdehnungskoeffizienten von Innenleiter und Glas in etwa gleich sind.

10. Herstellung einer Druckglasdurchführung nach Anspruch 1,
dadurch gekennzeichnet,
daß die Druckglasdurchführung in einen Metallkörper, bestehend aus der Legierung 9 % Ni, 10 % Sn, 0,3 % Mn, und Rest Cu, eine Glasperle bei 950 °C eingeschmolzen und ein Innenleiter eingesetzt wird und anschließend die Druckglasdurchführung mit einer Geschwindigkeit von etwa 25 °C min auf Raumtemperatur abgekühlt wird.

## Claims

1. Manufacture of compression glass seals with mounts made of alloys which can be precipitation-hardened, the glass being sealed as a glass bead into an opening of the metal body which is heated to a high temperature, then an inner conductor is inserted and then the compression glass seal is cooled to about room temperature, whereby the coefficient of expansion of the glass is lower than that of the metal and a processing temperature lies in the range of the solidus temperature of the metal or lower, and whereby the yield point of the metal may not be exceeded at any time during the cooling process,
characterized in that
a metal alloy made of the alloy system copper with spinodal precipitation-hardening is used,
and in that this alloy is cooled from a temperature of 800°C - 1000°C so quickly that a spinodal precipitation-hardening takes place, the rate of cooling being at least 10°C/min.

2. Manufacture of a compression glass seal according to Claim 1,
characterized in that
alloys of the composition Cu (remainder), 0.1 - 10% Ni 0.1 - 12% Sn 0 - 0.4% Mn are used.

3. Manufacture of a compression glass seal according to Claim 1,
characterized in that
alloys of the composition Cu (remainder), 0.1 - 5% Cr, 0.01 - 5% Zr are used.

4. Manufacture of a compression glass seal according to Claim 1,
characterized in that
an alloy of the system Al Cu Zn Mg is used.

5. Manufacture of a compression glass seal according to Claim 1,
characterized in that
glasses of the composition 65 % by wt. SiO₂, 5% Al₂O₃, 15% BaO + ZnO and 15% Na₂O + K₂O + Li₂O are used.

6. Manufacture of a compression glass seal according to Claim 1,
characterized in that
during the cooling process the temperature, preferably in the range of 250 - 450°C, is kept constant for several minutes up to several hours.

7. Manufacture of a compression glass seal according to Claim 1,
characterized in that,
after the cooling process, the compression glass seal is heated to a temperature between 250°C and 450°C,
preferably approx. 320°C, and is artificially aged for 1 minute up to 10 hours, preferably 2 to 6 hours.

8. Manufacture of a compression glass seal according to Claim 1,
characterized in that,
after the cooling process, the compression glass seal is heated to a temperature of at least 250°C and from there is heated by stages up to a maximum of 450°C and in the course of this is kept at each stage for between 1 minute and 2 hours.

9. Manufacture of a compression glass seal according to Claim 1,
characterized in that
the compression glass seal has one or more inner conductors embedded in the glass and insulated by this from the metal body, the coefficients of thermal expansion of inner conductor and glass being approximately the same.

10. Manufacture of a compression glass seal according to Claim 1,
characterized in that
the compression glass seal is sealed as a glass bead at 950°C into a metal body, consisting of the alloy 9% Ni, 10% Sn, 0.3% Mn and the remainder Cu, and an inner conductor is inserted and then the compression glass seal is cooled to room temperature at a rate of approximately 25°C/min.

## Revendications

1. Réalisation de traversées dans du verre moulé avec montures faites dans des alliages pouvant être durcis par précipitation, le verre, en tant que perle de verre, étant fondu dans une ouverture du corps métallique chauffé à une température élevée, un conducteur intérieur étant inséré ensuite, puis la traversée dans le verre moulé étant refroidie à peu près à la température ambiante, le coefficient de dilatation du verre étant inférieur à celui du métal et une température de traitement étant de l'ordre de la température solidus du métal ou inférieure et la limite d'élasticité du métal ne devant à aucun moment être dépassée pendant le refroidissement, caractérisée en ce qu'est utilisé un alliage métallique du système d'alliage du cuivre avec durcissement spinodal et en ce que cet alliage, à partir d'une température de 800 °C à 1 000 °C, est refroidi si rapidement qu'il se produit un durcissement spinodal, la vitesse de refroidissement étant au minimum de 10 °C/mn.

2. Réalisation d'une traversée dans du verre moulé selon la revendication 1, caractérisée en ce qu'on utilise des alliages de composition de Cu (reste), de 0,1 à 10 % de Ni, de 0,1 à 12 % de Sn, de 0 à 0,4 % de Mn.

3. Réalisation d'une traversée dans du verre moulé selon la revendication 1, caractérisée en ce qu'on utilise des alliages de composition de Cu (reste), de 0,1 à 5 % de Cr, de 0,01 à 5 % de Zr.

4. Réalisation d'une traversée dans du verre moulé selon la revendication 1, caractérisée en ce qu'on utilise un alliage du système Al Cu Zn Mg.

5. Réalisation d'une traversée dans du verre moulé selon la revendication 1, caractérisée en ce qu'on utilise des verres de composition de 65 % en poids de SiO₂, de 5 % de Al₂0₃, de 15 % de BaO + ZnO et de 15 % de Na₂O + K₂O + Li₂O.

6. Réalisation d'une traversée dans du verre moulé selon la revendication 1, caractérisée en ce que pendant le refroidissement la température, de préférence comprise entre 250 et 450 °C, est maintenue constante de plusieurs minutes à plusieurs heures.

7. Réalisation d'une traversée dans du verre moulé selon la revendication 1, caractérisée en ce que la traversée dans le verre moulé est chauffée, après le refroidissement, à une température comprise entre 250 °C et 450 °C, de préférence environ égale à 320 °C et est vieillie à chaud de 1 minute à 10 heures, de préférence de 2 à 6 heures.

8. Réalisation d'une traversée dans du verre moulé selon la revendication 1, caractérisée en ce que la traversée dans le verre moulé est chauffée, après le refroidissement, à une température d'au moins 250 °C et à partir de là, est chauffée progressivement jusqu'à 450 C au maximum et est maintenue ce faisant, dans chaque palier, de 1 minute à deux heures.

9. Réalisation d'une traversée dans du verre moulé selon la revendication 1, caractérisée en ce que la traversée dans le verre moulé comporte un ou plusieurs conducteurs intérieurs noyés dans le verre et isolés par celui-ci à l'égard du corps métallique, les coefficients de dilatation thermique du conducteur intérieur et du verre étant à peu près égaux.

10. Réalisation d'une traversée dans du verre moulé selon la revendication 1, caractérisée en ce que la traversée dans le verre moulé dans un corps métallique, constitué de l'alliage à 9 % de Ni, 10 % de Sn, 0,3 % de Mn et le reste de Cu, une perle de verre est fondue à 950 °C et un conducteur intérieur est inséré et ensuite la traversée dans le verre moulé est refroidie à une vitesse d'environ 25 °C/mn, à la température ambiante.
